# EUROPEAN PATENT APPLICATION

(11) **EP 4 625 836 A1**
(43) Date of publication of application: **01.10.2025**
(21) Application number: 22968866.8
(22) Date of filing: 20.12.2022
(51) Int. Cl.: H04B 7/06, H04B 7/0408

(54) **COMMUNICATION METHOD AND APPARATUS**

(71) Applicant: Huawei Technologies Co., Ltd., Shenzhen, Guangdong 518129 (CN)
(72) Inventor: LIU, Shangjing, Shenzhen, Guangdong 518129 (CN); CHEN, Yanyan, Shenzhen, Guangdong 518129 (CN); QI, Jiang, Shenzhen, Guangdong 518129 (CN)
(74) Representative: Maiwald GmbH
(86) International application number: PCT/CN2022/140506
(87) International publication number: WO 2024/130564

(57) **Abstract**

A communication method and apparatus relate to the field of communication technologies, so that the communication apparatus can adapt to development of a communication network when performing data transmission. The method may include: obtaining weight data; performing dimension reduction compression on the weight data, to obtain first data; and sending the first data, where the weight data is used for beamforming, and a dimension of the weight data is greater than a dimension of the first data.

## Description

### TECHNICAL FIELD

Embodiments of this application relate to the field of communication technologies, and in particular, to a communication method and apparatus.

### BACKGROUND

With rapid development of communication technologies, an air interface access rate continuously increases, and a communication network is developing in a direction of multiple antennas, multiple streams, and a large bandwidth.

However, development speed of a communication apparatus may not adapt to development speed of the communication network, to become a bottleneck that restricts development of the communication network.

Therefore, how the communication apparatus performs data transmission to adapt to development of the communication network becomes a technical problem to be urgently resolved.

### SUMMARY

This application provides a communication method and apparatus, so that the communication apparatus can adapt to development of a communication network when performing data transmission.

According to a first aspect, an embodiment of this application provides a communication method. The method may be applied to a first communication apparatus side. The method may include: obtaining weight data; performing dimension reduction compression on the weight data, to obtain first data; and sending the first data, where the weight data is used for beamforming, and a dimension of the weight data is greater than a dimension of the first data. That the weight data is used for beamforming may alternatively be described as: The weight data is used for a precoding operation.

Based on the first aspect, a data amount of the weight data may be reduced by performing dimension reduction compression on the weight data, to further reduce a data amount of data sent by a first communication apparatus through a fronthaul interface, and reduce a bandwidth requirement of the fronthaul interface, so that the first communication apparatus may adapt to the development of the communication network when performing data transmission through the fronthaul interface.

In a possible design, the dimension of the weight data is a quantity of antennas*a quantity of streams*a radio bearer RB quantity.

In a possible design, if a first condition is satisfied, dimension reduction compression is performed on the weight data, to obtain the first data. The first condition includes that a first transmission parameter associated with the weight data is greater than or equal to a first preset threshold, or a second transmission parameter associated with the weight data is less than or equal to a second preset threshold. The first transmission parameter includes one or more of the following: a quantity of streams, a quantity of antennas, a bandwidth, or fronthaul load, and the second transmission parameter includes a weight granularity.

Based on the possible design, the first communication apparatus may perform dimension reduction compression on the weight data when the first condition is satisfied, to relieve pressure of the fronthaul interface, reduce the bandwidth requirement of the fronthaul interface, and support a larger quantity of streams, a larger quantity of antennas, a smaller weight granularity, a larger bandwidth, higher fronthaul load, or the like. When a rate of a fronthaul optical module is given, a higher-specification wireless capability is enabled.

In a possible design, dimension reduction compression is performed on the weight data based on a first compression rate, to obtain the first data.

Based on the possible design, the first communication apparatus may perform dimension reduction compression on the weight data based on the first compression rate, to ensure that a data loss is controllable.

In a possible design, the first compression rate is preset; or the first compression rate is determined based on one or more of the following parameters: a quantity of streams, a quantity of antennas, a weight granularity, a bandwidth, or fronthaul load.

Based on the possible design, a plurality of feasible solutions are provided for the first communication apparatus to determine the first compression rate.

In a possible design, a difference between the dimension of the weight data and the dimension of the first data is a first difference, and an absolute value of a difference between a second compression rate determined based on the first difference and the first compression rate is less than or equal to the first threshold.

Based on the possible design, when the first communication apparatus performs dimension reduction compression on the weight data, the absolute value of the difference between the second compression rate and the first compression rate is less than or equal to the first threshold, to ensure that a data loss is controllable.

In a possible design, if a dimension reduction switch is in an on state, dimension reduction compression is performed on the weight data, to obtain the first data.

Based on the possible design, the first communication apparatus may perform dimension reduction compression when the dimension reduction switch is in an on state, and does not perform dimension reduction compression when the dimension reduction switch is in an off state.

In a possible design, dimension reduction compression is performed on the weight data in one or more of the following manners, to obtain the first data: a principal component analysis PCA manner, a discrete cosine transform DCT manner, or an autoencoder manner.

Based on the possible design, a plurality of feasible solutions are provided for the first communication apparatus to perform dimension reduction compression on the weight data.

In a possible design, the first data is quantized to obtain quantized first data; and the quantized first data is sent.

Based on the possible design, the first data obtained through dimension reduction compression may be quantized on the basis of dimension reduction compression performed on the weight data, to achieve an effect of multiplying a compression capability, and further improve a compression effect of the weight data.

In a possible design, the first communication apparatus includes one or more of the following: a high-specification baseband unit BBH, a central unit CU, a distributed unit DU, a baseband processing unit BBU, or a unit less than the BBH.

Based on the possible design, a plurality of feasible solutions are provided for designing of the first communication apparatus.

According to a second aspect, an embodiment of this application provides a communication method. The method is applied to a second communication apparatus side. The method may include: obtaining first data, and performing dimension increase decompression on the first data, to obtain weight data, where the weight data is used for beamforming, and a dimension of the weight data is greater than a dimension of the first data. That the weight data is used for beamforming may alternatively be described as: The weight data is used for a precoding operation.

Based on the second aspect, a data amount of the weight data may be reduced by performing dimension reduction compression on the weight data, to further reduce a data amount of data received by a second communication apparatus through a fronthaul interface, and reduce a bandwidth requirement of the fronthaul interface, so that the second communication apparatus may adapt to the development of the communication network when performing data transmission through the fronthaul interface.

In a possible design, the dimension of the weight data is a quantity of antennas*a quantity of streams*a radio bearer RB quantity.

In a possible design, dimension increase decompression is performed on the first data based on a first compression rate, to obtain the weight data.

Based on the possible design, the second communication apparatus may perform dimension increase decompression on the weight data based on the first compression rate, to ensure that a data loss is controllable.

In a possible design, the first compression rate is preset; or the first compression rate is determined based on one or more of the following parameters: a quantity of streams, a quantity of antennas, a weight granularity, a bandwidth, or fronthaul load.

Based on the possible design, a plurality of feasible solutions are provided for the second communication apparatus to determine the first compression rate.

In a possible design, a difference between the dimension of the weight data and the dimension of the first data is a first difference, and an absolute value of a difference between a second compression rate determined based on the first difference and the first compression rate is less than or equal to the first threshold.

Based on the possible design, when the first communication apparatus performs dimension reduction compression on the weight data, the absolute value of the difference between the second compression rate and the first compression rate is less than or equal to the first threshold, to ensure that a data loss is controllable.

In a possible design, dimension increase decompression is performed on the first data in one or more of the following manners, to obtain the weight data: a principal component analysis PCA manner, a discrete cosine transform DCT manner, or an autoencoder manner.

Based on the possible design, a plurality of feasible solutions are provided for the second communication apparatus to perform dimension increase decompression on the weight data.

In a possible design, quantized first data is received, and the quantized first data is dequantized, to obtain the first data.

Based on the possible design, the first communication apparatus quantizes, on the basis of dimension reduction compression performed on the weight data, the first data obtained through dimension reduction compression, to achieve an effect of multiplying a compression capability, and further improve a compression effect of the weight data.

In a possible design, the second communication apparatus includes one or more of the following: a low-specification baseband unit BBL, a remote radio unit RRU, an active antenna unit AAU, or a unit less than the BBL.

Based on the possible design, a plurality of feasible solutions are provided for designing of the second communication apparatus.

According to a third aspect, an embodiment of this application provides a communication apparatus. The communication apparatus may be used in the first communication apparatus in the first aspect or the possible designs of the first aspect, to implement a function performed by the first communication apparatus. The communication apparatus may be the first communication apparatus, may be a chip or a system on chip of the first communication apparatus, may be a software module that can implement a function in the first aspect, or the like. The communication apparatus may perform, by using hardware, the function performed by the first communication apparatus, or may execute corresponding software by using hardware. The hardware or the software includes one or more modules corresponding to the foregoing function, for example, a transceiver module and a processing module. The transceiver module is configured to obtain weight data, where the weight data is used for beamforming. The processing module is configured to perform dimension reduction compression on the weight data, to obtain first data, where a dimension of the weight data is greater than a dimension of the first data. The transceiver module is further configured to send the first data.

In a possible design, the dimension of the weight data is a quantity of antennas*a quantity of streams*a radio bearer RB quantity.

In a possible design, the processing module is specifically configured to: if a first condition is satisfied, perform dimension reduction compression on the weight data, to obtain the first data. The first condition includes that a first transmission parameter associated with the weight data is greater than or equal to a first preset threshold, or a second transmission parameter associated with the weight data is less than or equal to a second preset threshold. The first transmission parameter includes one or more of the following: a quantity of streams, a quantity of antennas, a bandwidth, or fronthaul load, and the second transmission parameter includes a weight granularity.

In a possible design, the processing module is specifically configured to perform dimension reduction compression on the weight data based on a first compression rate, to obtain the first data.

In a possible design, the first compression rate is preset; or the first compression rate is determined based on one or more of the following parameters: a quantity of streams, a quantity of antennas, a weight granularity, a bandwidth, or fronthaul load.

In a possible design, a difference between the dimension of the weight data and the dimension of the first data is a first difference, and an absolute value of a difference between a second compression rate determined based on the first difference and the first compression rate is less than or equal to the first threshold.

In a possible design, the processing module is specifically configured to: if a dimension reduction switch is in an on state, perform dimension reduction compression on the weight data, to obtain the first data.

In a possible design, the processing module is specifically configured to perform dimension reduction compression on the weight data in one or more of the following manners, to obtain the first data: a principal component analysis PCA manner, a discrete cosine transform DCT manner, or an autoencoder manner.

In a possible design, the processing module is further configured to quantize the first data, to obtain quantized first data, and the transceiver module is further configured to send the quantized first data.

In a possible design, the first communication apparatus includes one or more of the following: a high-specification baseband unit BBH, a central unit CU, a distributed unit DU, a baseband processing unit BBU, or a unit less than the BBH.

It should be noted that the modules in the third aspect or the possible designs of the third aspect may perform the corresponding functions in the method examples in the first aspect. For details, refer to the detailed descriptions in the method examples. For beneficial effect, refer to the related descriptions in the first aspect. Details are not described herein.

According to a fourth aspect, an embodiment of this application provides a communication apparatus. The communication apparatus may be used in the second communication apparatus in the second aspect or the possible designs of the second aspect, to implement a function performed by the second communication apparatus. The communication apparatus may be the second communication apparatus, may be a chip or a system on chip of the second communication apparatus, may be a software module that can implement the function in the second aspect, or the like. The communication apparatus may perform, by using hardware, the function performed by the second communication apparatus, or may execute corresponding software by using hardware. The hardware or the software includes one or more modules corresponding to the foregoing function, for example, a transceiver module and a processing module. The transceiver module is configured to obtain first data. The processing module is configured to perform dimension increase decompression on the first data, to obtain weight data, where the weight data is used for beamforming, and a dimension of the weight data is greater than a dimension of the first data.

In a possible design, the dimension of the weight data is a quantity of antennas*a quantity of streams*a radio bearer RB quantity.

In a possible design, the processing module is specifically configured to perform dimension increase decompression on the first data based on a first compression rate, to obtain the weight data.

In a possible design, the first compression rate is preset; or the first compression rate is determined based on one or more of the following parameters: a quantity of streams, a quantity of antennas, a weight granularity, a bandwidth, or fronthaul load.

In a possible design, a difference between the dimension of the weight data and the dimension of the first data is a first difference, and an absolute value of a difference between a second compression rate determined based on the first difference and the first compression rate is less than or equal to the first threshold.

In a possible design, the processing module is specifically configured to perform dimension increase decompression on the first data in one or more of the following manners, to obtain the weight data: a principal component analysis PCA manner, a discrete cosine transform DCT manner, or an autoencoder manner.

In a possible design, the transceiver module is further configured to receive quantized first data, and the processing module is further configured to dequantize the quantized first data, to obtain the first data.

In a possible design, the second communication apparatus includes one or more of the following: a low-specification baseband unit BBL, a remote radio unit RRU, an active antenna unit AAU, or a unit less than the BBL.

It should be noted that the modules in the fourth aspect or the possible designs of the fourth aspect may perform the corresponding functions in the method examples in the second aspect. For details, refer to the detailed descriptions in the method examples. For beneficial effect, refer to the related descriptions in the second aspect. Details are not described herein.

According to a fifth aspect, an embodiment of this application provides a communication apparatus. The communication apparatus includes one or more processors. The one or more processors are configured to run a computer program or instructions. When the one or more processors execute computer instructions or the instructions, the communication apparatus is enabled to perform the communication method according to any one of the first aspect and the second aspect.

In a possible design, the communication apparatus further includes one or more memories. The one or more memories are coupled to the one or more processors, and the one or more memories are configured to store the computer program or the instructions. In a possible implementation, the memory is located outside the communication apparatus. In another possible implementation, the memory is located inside the communication apparatus. In this embodiment of this application, the processor and the memory may alternatively be integrated into one component. In other words, the processor and the memory may alternatively be integrated together. In a possible implementation, the communication apparatus further includes a transceiver. The transceiver is configured to receive information and/or send information.

In a possible design, the communication apparatus further includes one or more communication interfaces. The one or more communication interfaces are coupled to the one or more processors, and the one or more communication interfaces are configured to communicate with a module other than the communication apparatus.

According to a sixth aspect, an embodiment of this application provides a communication apparatus. The communication apparatus includes an input/output interface and a logic circuit. The input/output interface is configured to input and/or output information. The logic circuit is configured to perform the communication method according to any one of the first aspect and the second aspect, to perform processing based on information and/or generate information.

According to a seventh aspect, an embodiment of this application provides a computer-readable storage medium. The computer-readable storage medium stores computer instructions or a program. When the computer instructions or the program is run on a computer, the communication method according to any one of the first aspect and the second aspect is performed.

According to an eighth aspect, an embodiment of this application provides a computer program product including computer instructions. When the computer program product is run on a computer, the communication method according to any one of the first aspect and the second aspect is performed.

According to a ninth aspect, an embodiment of this application provides a computer program. When the computer program is run on a computer, the communication method according to any one of the first aspect and the second aspect is performed.

For technical effects brought by any one of the designs of the fifth aspect to the ninth aspect, refer to the technical effects brought by any one of the first aspect and the second aspect.

According to a tenth aspect, an embodiment of this application provides a communication system. The communication system may include the first communication apparatus according to the third aspect and the second communication apparatus according to the fourth aspect.

### BRIEF DESCRIPTION OF DRAWINGS

FIG. 1 is a diagram of an association between a band and a bandwidth according to an embodiment of this application;
FIG. 2 is a diagram of user data and weight data according to an embodiment of this application;
FIG. 3 is a diagram of a communication system according to an embodiment of this application;
FIG. 4 is a diagram of an access network device according to an embodiment of this application;
FIG. 5 is a diagram of an access network device according to an embodiment of this application;
FIG. 6 is a diagram of a fronthaul interface according to an embodiment of this application;
FIG. 7 is a compositional diagram of a communication apparatus according to an embodiment of this application;
FIG. 8 is a flowchart of a communication method according to an embodiment of this application;
FIG. 9 is a diagram of weight data processing according to an embodiment of this application;
FIG. 10 is a diagram of an autoencoder according to an embodiment of this application;
FIG. 11 is a diagram of performing dimension reduction compression on weight data based on a TTI according to an embodiment of this application;
FIG. 12 is a diagram of weight data processing according to an embodiment of this application;
FIG. 13 is a diagram of a communication apparatus according to an embodiment of this application; and
FIG. 14 is a compositional diagram of a communication apparatus according to an embodiment of this application.

### DESCRIPTION OF EMBODIMENTS

Before embodiments of this application are described, technical terms used in embodiments of this application are described.

A fronthaul interface is, for example, an architecture based on a remote radio unit (remote radio unit, RRU)/an active antenna unit (active antenna unit, AAU) and a baseband processing unit (building baseband unit, BBU). An interface between the RRU/AAU and the BBU may be referred to as the fronthaul interface. For more descriptions of the fronthaul interface, refer to below.

For example, the fronthaul interface may include one or more of the following: a common public radio interface (common public radio interface, CPRI) or an enhanced common public radio interface (enhanced common public radio interface, eCPRI).

With rapid development of communication technologies (for example, 5.5G), an air interface access rate continuously increases, and a communication network (or described as a radio network) develops in a direction of multiple antennas (for example, including 128 transmit channels (128 transmit, 128T)), multiple streams, and a large bandwidth (for example, 400 megahertz (megahertz, MHz)). As a result, a bandwidth requirement based on the fronthaul interface continuously increases.

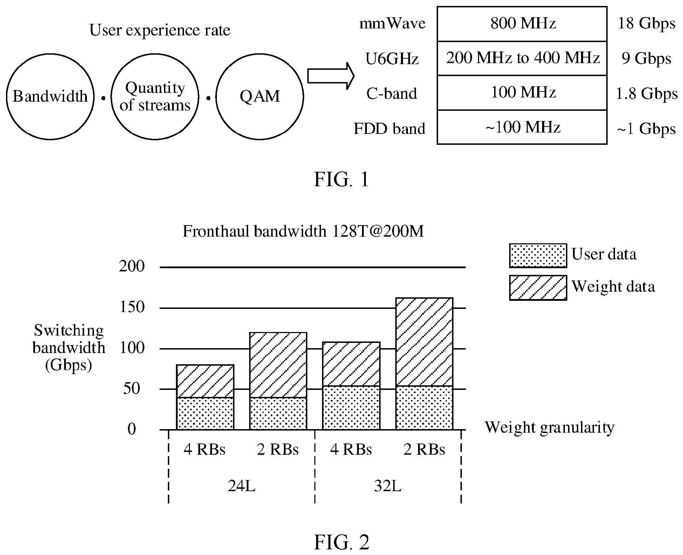

For example, as shown in FIG. 1, a millimeter wave (mmWave) may correspond to a bandwidth of 800 MHz and a rate of 18 gigabits per second (gigabits per second, Gbps). An under 6GHz (under 6GHz, U6GHz) band may correspond to a bandwidth of 200 MHz to 400 MHz and a rate of 9 Gbps. A C-band (C-band) may correspond to a bandwidth of 100 MHz and a rate of 1.8 Gbps. A frequency division duplex (frequency division duplex, FDD) band () may correspond to ~100 MHz and ~1 Gbps, where "~" represents about. It can be learned that an ultra-large bandwidth is a cornerstone of high rate, such as 10 Gbps. Sub 100G is fully used to achieve 10 Gbps experience and improve a user experience rate. A value of the user experience rate may depend on one or more of the following: a bandwidth, a quantity of streams, or quadrature amplitude modulation (quadrature amplitude modulation, QAM).

However, development speed of a communication apparatus may not adapt to development speed of the communication network, to become a bottleneck that restricts development of the communication network.

For example, a module configured to implement a fronthaul interface function includes a fronthaul optical module. A baseband signal may be transmitted from the BBU to the AAU/RRU through the fronthaul interface. If a transmission rate of the fronthaul optical module is low, the baseband signal cannot be transmitted to the AAU/RRU at a higher rate. Consequently, radio performance cannot be further improved, to be specific, the fronthaul optical module may become a bottleneck that restricts the development of the communication network.

For example, the fronthaul interface is an eCPRI. With development of multiple antennas and a large bandwidth, a bandwidth of the eCPRI is also insufficient. A new communication method needs to be proposed, so that a capability of the fronthaul interface can support development of multiple antennas and a large bandwidth.

For example, the eCPRI may be re-split. However, in the method, a hardware architecture of the communication network needs to be greatly changed, and costs are high. In addition to an eCPRI re-split technology, a solution that does not change the hardware architecture or change the hardware architecture slightly may also be researched.

Specifically, data in the eCPRI mainly includes user data and weight data. As a quantity of antennas and the bandwidth increase, a required bandwidth of the eCPRI also increases, and a proportion of the weight data in the overall data in the eCPRI continuously increases (where the proportion can be close to 80% at most). However, currently, the bandwidth of the eCPRI is limited. As a result, the eCPRI may not support wireless development.

The user data may be downlink data, for example, data that is transmitted to the RRU/AAU through the BBU and then sent by an antenna to a terminal device through an air interface. The user data may alternatively be uplink data, for example, data that is received by an antenna through an air interface and then transmitted by the RRU/AAU to the BBU.

The weight data may be a value used for beamforming, and a value may be multiplied by a data part (such as the user data or control data) in a precoding phase to form a directional beam, to achieve an effect of space division multiplexing. The weight data may be preconfigured, configured through an operation interface, estimated based on an uplink reference signal, or calculated based on channel information fed back by the terminal device. This is not limited.

For example, as shown in FIG. 2, a communication scenario in which a fronthaul bandwidth is 128T@200 MHz is used as an example, and the weight data accounts for a large proportion. For a weight granularity, when the weight granularity is 4 RBs, the proportion of the weight data is about 50%. When the weight granularity is 2 RBs, the proportion of the weight data is about 70%. When the weight granularity is 1 RB, the proportion of the weight data is about 80%. In other words, the proportion of the weight data increases with the weight granularity decreases. The RB is a resource block (resource block). For a quantity of streams, in comparison with a scenario in which a quantity of streams is 24 (24L), when a quantity of streams is 32L, both a data amount of the weight data and a data amount of the user data continuously increase. In other words, the data amount of the weight data and the data amount of the user data increase as the quantity of streams increases.

When a weight granularity is 4 RBs and a quantity of streams is 24L, a required switching bandwidth is greater than 50 Gbps and less than 100 Gbps, and a required eCPRI may be an eCPRI of 100 Gbps. When a weight granularity is 2 RBs and a quantity of streams is 24L, a required switching bandwidth is greater than 100 Gbps and less than 150 Gbps, and a required eCPRI may be an eCPRI of 150 Gbps. When a weight granularity is 4 RBs and a quantity of streams is 32L, a required switching bandwidth is greater than 100 Gbps and less than 150 Gbps, and a required eCPRI may be an eCPRI of 150 Gbps. When a weight granularity is 2 RBs and a quantity of streams is 32L, a required switching bandwidth is greater than 150 Gbps and less than 200 Gbps, and a required eCPRI may be an eCPRI of 200 Gbps.

The weight granularity may indicate a quantity of RBs corresponding to one piece of weight data. For example, 4 RBs may indicate that data corresponding to every 4 RBs is associated with same weight data.

However, because development speed of the fronthaul optical module cannot adapt to development speed of the communication network, there may be no eCPRI of 150 Gbps or eCPRI of 200 Gbps. As a result, the communication apparatus cannot perform high-speed data transmission through the eCPRI, and an increasing communication requirement cannot be met.

In conclusion, how the communication apparatus performs data transmission through the fronthaul interface to adapt to development of the communication network becomes a technical problem to be urgently resolved.

To resolve the foregoing technical problem, an embodiment of this application provides a communication method. In the method, after obtaining weight data, a first communication apparatus may perform dimension reduction compression on the weight data, to obtain first data, and then send the first data, where the weight data is used for beamforming, and a dimension of the weight data is greater than a dimension of the first data.

In this embodiment of this application, a data amount of the weight data can be reduced by performing dimension reduction compression on the weight data, to further reduce a data amount of data sent by the first communication apparatus through a fronthaul interface, and reduce a bandwidth requirement of the fronthaul interface, so that the first communication apparatus may adapt to development of a communication network when performing data transmission through the fronthaul interface.

The following describes implementations of embodiments of this application in detail with reference to accompanying drawings in this specification.

The communication method provided in embodiments of this application may be applied to any communication system. The communication system may be a 3rd generation partnership project (3rd generation partnership project, 3GPP) communication system, such as a long term evolution (long term evolution, LTE) system, a 5th generation (5th generation, 5G) mobile communication system, a new radio (new radio, NR) communication system, or a vehicle-to-everything (vehicle-to-everything, V2X) system. Alternatively, the communication method may be applied to an LTE and 5G hybrid networking system, or may be applied to a non-terrestrial network (non-terrestrial network, NTN) system, a device-to-device (device-to-device, D2D) communication system, a machine-to-machine (machine-to-machine, M2M) communication system, internet of things (internet of things, IoT), a near field communication (near field communication, NFC) system, a microwave communication (uWave) system, and another next generation communication system, for example, a future communication system such as 6G, or may be a non-3GPP communication system, for example, a wireless local area network (wireless local area network, WLAN). This is not limited.

It should be noted that the foregoing communication system applicable to this application is merely an example for description, and a communication system applicable to this application is not limited thereto. Unified descriptions are provided herein. Details are not described below again.

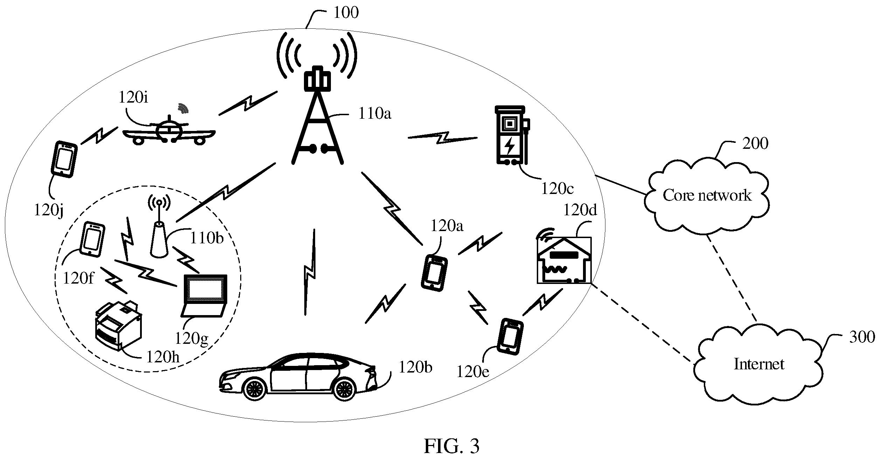

The following uses FIG. 3 as an example to describe a communication system provided in an embodiment of this application.

FIG. 3 is a diagram of a possible and non-limiting system. As shown in FIG. 3, the communication system includes a radio access network (radio access network, RAN) 100 and a core network (core network, CN) 200. The RAN 100 includes at least one RAN node (for example, 110a and 110b in FIG. 3, collectively referred to as 110) and at least one terminal device (for example, 120a to 120j in FIG. 3, collectively referred to as 120). The RAN 100 may also include another RAN node, for example, a wireless relay device and/or a wireless backhaul device (not shown in FIG. 3). The terminal device 120 is connected to the RAN node 110 in a wireless manner. The RAN node 110 is connected to the core network 200 in a wireless or wired manner. A core network device in the core network 200 and the RAN node 110 in the RAN 100 may respectively be different physical devices, or may be a same physical device that integrates a core network logical function and a radio access network logical function.

The RAN 100 may be a cellular system related to a 3rd generation partnership project (3rd generation partnership project, 3GPP), for example, a 4G or 5G mobile communication system or a future-oriented evolved system (for example, a 6G mobile communication system). The RAN 100 may alternatively be an open access network (open RAN, O-RAN, or ORAN) or a cloud radio access network (cloud radio access network, CRAN) system. Alternatively, the RAN 100 may be a communication system that integrates the foregoing two or more systems.

The RAN node 110 may also be sometimes referred to as an access network device, a RAN entity, an access node, or the like, and forms a part of a communication system, to help a terminal device implement radio access. A plurality of RAN nodes 110 in the communication system 1000 may be a same type of nodes, or may be different types of nodes. In some scenarios, roles of the RAN node 110 and the terminal device 120 are relative. For example, a network element 120i in FIG. 3 may be a helicopter or an uncrewed aerial vehicle, and may be configured as a mobile base station. For a terminal device 120j that accesses the RAN 100 through the network element 120i, the network element 120i is a base station. However, for the base station 110a, the network element 120i is a terminal device. The RAN node 110 and the terminal device 120 are sometimes referred to as communication apparatuses. For example, network elements 110a and 110b in FIG. 3 may be understood as communication apparatuses having a base station function, and the network elements 120a to 120j may be understood as communication apparatuses having a terminal device function.

In a possible scenario, the RAN node may be a base station (base station), an evolved base station (evolved NodeB, eNodeB), an access point (access point, AP), a transmission reception point (transmission reception point, TRP), a next generation base station (next generation NodeB, gNB), a next generation base station in a 6th generation (6th generation, 6G) mobile communication system, a base station in a future mobile communication system, an access node in a Wi-Fi system, or the like. The RAN node may be a macro base station (110a in FIG. 3), a micro base station or an indoor station (110b in FIG. 3), a relay node or a donor node, or a radio controller in a CRAN scenario. Optionally, the RAN node may alternatively be a server, a wearable device, a vehicle, a vehicle-mounted device, or the like. For example, an access network device in a vehicle-to-everything (vehicle-to-everything, V2X) technology may be a road side unit (road side unit, RSU).

In another possible scenario, a plurality of RAN nodes coordinate to assist the terminal device in implementing radio access, and different RAN nodes separately implement some functions of a base station. For example, the RAN node may be a central unit (central unit, CU), a distributed unit (distributed unit, DU), a CU-control plane (control plane, CP), a CU-user plane (user plane, UP), a radio unit (radio unit, RU), or the like. The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may also have different names, but a person skilled in the art may understand their meanings. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination thereof.

The terminal device may also be referred to as a terminal, user equipment (user equipment, UE), a mobile station, a mobile terminal, or the like. The terminal device may be widely used in various scenarios, for example, device-to-device (device-to-device, D2D), vehicle-to-everything (vehicle-to-everything, V2X) communication, machine-type communication (machine-type communication, MTC), internet of things (internet of things, IoT), virtual reality, augmented reality, industrial control, self-driving, telemedicine, a smart grid, smart furniture, smart office, smart wearable, smart transportation, and a smart city. The terminal device may be a mobile phone, a tablet computer, a computer with a wireless transceiver function, a wearable device, a vehicle, an uncrewed aerial vehicle, a helicopter, an airplane, a ship, a robot, a robot arm, a smart home device, or the like. A device form of the terminal device is not limited in embodiments of this application.

Communication between the access network device and the terminal device complies with a specific protocol layer structure. A protocol layer may include a control plane protocol layer and a user plane protocol layer. The control plane protocol layer may include at least one of the following: a radio resource control (radio resource control, RRC) layer, a packet data convergence protocol (packet data convergence protocol, PDCP) layer, a radio link control (radio link control, RLC) layer, a medium access control (media access control, MAC) layer, or a physical (physical, PHY) layer. The user plane protocol layer may include at least one of the following: a service data adaptation protocol (service data adaptation protocol, SDAP) layer, a PDCP layer, an RLC layer, a MAC layer, a physical layer, or the like.

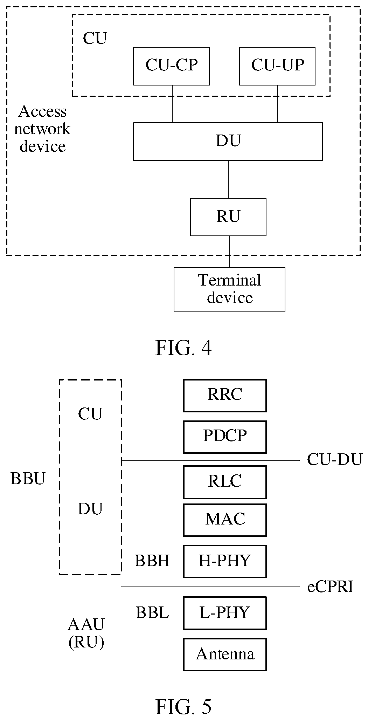

FIG. 4 is a diagram of a radio access network RAN. As shown in FIG. 4, the access network device includes one or more CUs, one or more DUs, and one or more radio units (radio unit, RU). For clarity, FIG. 4 shows only one CU, one DU, and one RU. The CU is configured to be connected to a core network and the one or more DUs. Optionally, the CU may have some functions of the core network. The CU may include a CU-CP and a CU-UP.

The CU and the DU may be configured based on a protocol layer function of a radio network implemented by the CU and the DU. For example, the CU is configured to implement functions of a PDCP layer and a protocol layer (for example, an RRC layer and/or an SDAP layer) above the PDCP layer, and the DU is configured to implement a function of a protocol layer (for example, an RLC layer, a MAC layer, and/or a PHY layer) below the PDCP layer. For another example, the CU is configured to implement a function of a protocol layer (for example, an RRC layer and/or an SDAP layer) above a PDCP layer, and the DU is configured to implement functions of the PDCP layer and a protocol layer (for example, an RLC layer, a MAC layer, and/or a PHY layer) below the PDCP layer.

When the CU includes the CU-CP and the CU-UP, the CU-CP is configured to implement a control plane function of the CU, and the CU-UP is configured to implement a user plane function of the CU. For example, when the CU is configured to implement functions of the PDCP layer, the RRC layer, and the SDAP layer, the CU-CP is configured to implement the function of the RRC layer and a control plane function of the PDCP layer, and the CU-UP is configured to implement the function of the SDAP layer and a user plane function of the PDCP layer.

The configuration of the CU and the DU is merely an example. Alternatively, functions of the CU and the DU may be configured based on a requirement. For example, the CU or the DU may be configured to have functions of more protocol layers, or the CU or the DU may be configured to have some processing functions of a protocol layer. For example, some functions of the RLC layer and functions of a protocol layer above the RLC layer are set on the CU, and remaining functions of the RLC layer and functions of a protocol layer below the RLC layer are set on the DU. For another example, division of functions of the CU or the DU may be performed based on a service type or another system requirement, for example, based on a latency. Functions whose processing time needs to satisfy a short latency requirement are set on the DU, and functions whose processing time does not need to satisfy the short latency requirement are set on the CU.

For example, as shown in FIG. 5, the DU and the RU may be split or separated at the PHY layer. The DU and the RU may cooperate to jointly implement a function of the PHY layer. One DU may be connected to one or more RUs. Functions of the DU and the RU may be configured in a plurality of manners based on a design. For example, the DU is configured to implement a baseband function, and the RU is configured to implement an intermediate radio frequency function. For another example, the DU is configured to implement a higher-layer function of the PHY layer (or described as implementing an H(high)-PHY function), and the RU is configured to implement a lower-layer function of the PHY layer (or described as implementing an L(low)-PHY function) or implement the lower-layer function and a radio frequency function. The high-layer function of the physical layer may include a part of functions of the physical layer, and the part of functions is closer to the MAC layer. The lower-layer function of the physical layer may include another part of functions of the physical layer, and the another part of functions is closer to an intermediate radio frequency side. A manner of splitting the DU and the RU may be various possible manners. This is not limited. There is an interface between the DU and the RU. For example, based on different functions of the DU and the RU and/or different splitting manners, the interface between the DU and the RU may be a CPRI or an eCPRI.

For example, in a possible design, the H-PHY function may include one or more of the following: forward error correction (forward error correction, FEC) encoding/decoding, scrambling, or modulation/demodulation. The L-PHY function may include one or more of the following: fast Fourier transform (fast Fourier transform, FFT)/inverse fast Fourier transform (inverse fast Fourier transform, iFFT), digital beamforming, extraction and filtering of a physical random access channel (physical random access channel, PRACH), or the like. The RU may perform radio frequency signal communication with the terminal device through an air interface via an antenna.

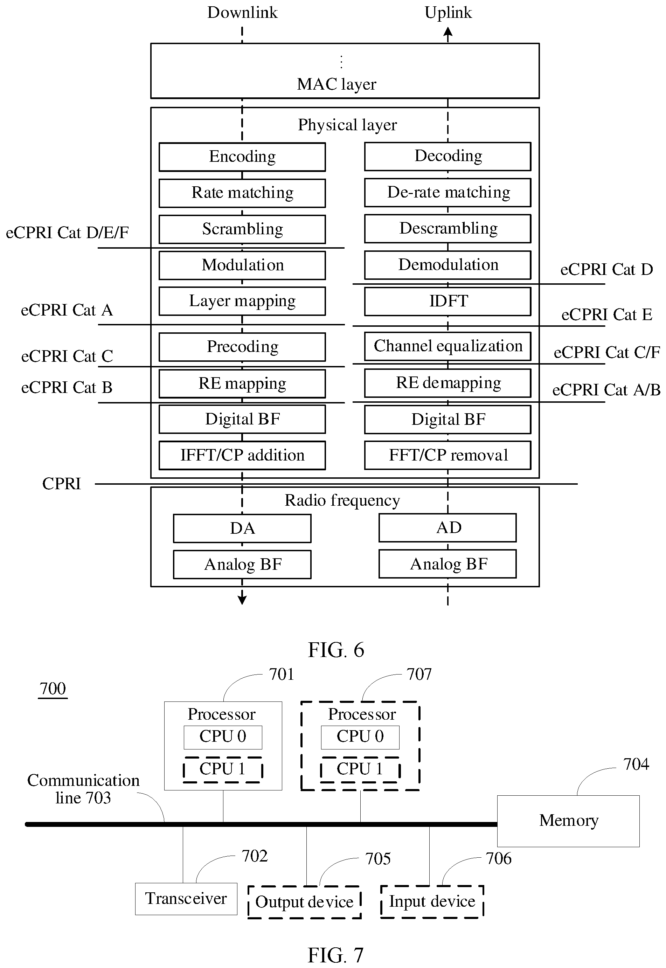

FIG. 6 is a diagram of an architecture of an access network device. The access network device includes one or more functional modules, configured to implement signal processing. As shown in FIG. 6, a function of a physical layer is used as an example. The access network device includes one or more of the following functions: encoding, rate matching, scrambling, modulation, layer mapping, precoding, resource element (resource element, RE) mapping, digital beamforming (beamforming, BF), inverse fast Fourier transform (inverse fast Fourier transform, IFFT)/cyclic prefix (cyclic prefix, CP) addition, decoding, de-rate matching, descrambling, demodulation, inverse discrete Fourier transform (inverse discrete Fourier transform, IDFT), channel equalization (or channel estimation), RE demapping, digital BF, fast Fourier transform (fast Fourier transform, FFT)/CP removal, digital-to-analog (digital-to-analog, DA) conversion, analog BF, analog-to-digital (analog-to-digital, AD) conversion, or analog BF.

The one or more functional modules may be implemented by using software, hardware, or a combination of software and hardware. Physically, the one or more functional modules may be discrete or integrated. It may be understood that the foregoing functional modules are merely examples. The access network device may include more other modules (for example, a scheduling module, a power control module, a hybrid automatic repeat request (hybrid automatic repeat request, HARQ) module, a stream control module, a mobility management module, or an artificial intelligence (artificial intelligence, AI) module) based on a design, or does not include a specific functional module shown in FIG. 6 (for example, do not include a digital BF module). The access network device further includes a fronthaul (fronthaul, FH) interface between the DU and the RU, to implement communication between the DU and the RU. The fronthaul interface includes but is not limited to a CPRI or an eCPRI. In a possible implementation, the DU is located in the BBU, the RU is located in the RRU/AAU/RRH, and an interface between the BBU and the RRU/AAU/RRH may also be referred to as a fronthaul interface. To implement the fronthaul interface, the BBU and the RRU/AAU/RRH may be connected via a fronthaul network, or the DU and the RU may be connected via the fronthaul network. For example, the fronthaul network includes but is not limited to a fiber direct connection network and a wavelength division multiplexing network.

The access network device may support one or more types of fronthaul interfaces, and different fronthaul interfaces are respectively corresponding to DUs and RUs having different functions. As shown in FIG. 6, if the fronthaul interface between the DU and the RU is a CPRI, the DU is configured to implement one or more of baseband functions, and the RU is configured to implement one or more of radio frequency functions. In comparison with a CPRI, if the fronthaul interface between the DU and the RU is an eCPRI, some downlink and/or uplink baseband functions are moved from the DU to the RU. Split manners of the DU and the RU are different, and correspond to different categories (category, Cat for short) of eCPRIs.

FIG. 6 shows examples of six eCPRIs. The eCPRIs are represented by cats A, B, C, D, E, and F (which may also be represented as options A to F, options 1 to 6, or another manner). It may be understood that there may be another split manner between the DU and the RU, in other words, there may be another category of eCPRIs.

The eCPRI cat A is used as an example. For downlink transmission, layer mapping is used as splitting. The DU is configured to implement the layer mapping and one or more previous functions (in other words, one or more of encoding, rate matching, scrambling, modulation, and layer mapping), and another function (for example, RE mapping, digital BF, or IFFT/CP addition) after the layer mapping is moved to the RU for implementation. For uplink transmission, RE demapping is used as splitting. The DU is configured to implement demapping and one or more previous functions (in other words, one or more of decoding, de-rate matching, descrambling, demodulation, IDFT, channel equalization, and RE demapping), and another function (for example, one or more of digital BF or FFT/CP removal) after the demapping is moved to the RU for implementation.

Similarly, the eCPRIs cat B, cat C, cat D, cat E, and cat F respectively correspond to different split manners of the DU and the RU. Functions of a split point and before the split point are implemented by the DU, and a function after the split point is implemented by the RU. For split points of various categories of eCPRIs, refer to FIG. 6. Details are not described one by one. For example, for the eCPRI cat B, RE mapping is used as split of downlink transmission, and RE demapping is used as split of uplink transmission. For the uplink transmission, functions of the RE mapping and before the RE mapping are implemented by the DU, and a function after the RE mapping and a radio frequency function are implemented by the RU. For the downlink transmission, functions of the RE demapping and before the RE demapping are implemented by the DU, and a function after the RE demapping and a radio frequency function are implemented by the RU.

An eCPRI split manner may be symmetric for uplink and downlink, for example, the eCPRIs cat B and cat C shown in FIG. 6. Alternatively, an eCPRI split manner may be asymmetric for uplink and downlink, for example, the eCPRIs cat A, cat D, cat E, and cat F shown in FIG. 6. This is not limited. Optionally, for the uplink and/or the downlink, different split manners may be configured for different channels or different channel groups, in other words, different categories of eCPRIs are configured. A group of channels may include one or more channels.

In a possible design, the DU is located in the BBU, and the RU is located in the RRU/AAU/RRH. A processing unit configured to implement a baseband function in the BBU is referred to as a baseband higher-layer or high-specification baseband (baseband high, BBH) unit, and a processing unit configured to implement a baseband function in the RRU/AAU/RRH is referred to as a baseband lower-layer or low-specification baseband (baseband low, BBL) unit.

Based on the foregoing descriptions of the access network device, the communication method provided in this embodiment of this application may be applied to a first communication apparatus side and a second communication apparatus side. For example, the first communication apparatus may include one or more of the following: a BBH, a CU, a DU, a BBU, a unit less than the BBH, or the like, or include a software module, a hardware circuit, or a software module and a hardware circuit that can be installed or connected to these modules to implement the method in this embodiment of this application. This is not limited. The second communication apparatus may include one or more of the following: a BBL, an RRU, an AAU, a unit less than the BBL, or the like, or include a software module, a hardware circuit, or a software module and a hardware circuit that can be installed or connected to these modules to implement the method in this embodiment of this application. This is not limited.

It should be noted that the first communication apparatus and the second communication apparatus in this embodiment of this application may be one or more chips, may be system on chips (system on chip, SOC), or the like. FIG. 3 to FIG. 6 are merely examples of the accompanying drawings, and a quantity of devices included in FIG. 3 to FIG. 6 is not limited. In addition, in addition to the devices shown in FIG. 3 to FIG. 6, the communication system may further include another device. Names of the devices and of links in FIG. 3 to FIG. 6 are not limited. In addition to the names shown in FIG. 3 to FIG. 6, the devices and the links may have other names. This is not limited.

During specific implementation, as shown in FIG. 3 to FIG. 6, for example, both the first communication apparatus and the second communication apparatus may use a composition structure shown in FIG. 7, or include components shown in FIG. 7. FIG. 7 is a compositional diagram of a communication apparatus 700 according to an embodiment of this application. The communication apparatus 700 may be a first communication apparatus or a chip or a system on chip in the first communication apparatus, or may be a second communication apparatus or a chip or a system on chip in the second communication apparatus. As shown in FIG. 7, the communication apparatus 700 includes a processor 701, a transceiver 702, and a communication line 703.

Further, the communication apparatus 700 may include a memory 704. The processor 701, the memory 704, and the transceiver 702 may be connected via the communication line 703.

The processor 701 is a central processing unit (central processing unit, CPU), a generalpurpose processor, a network processor (network processor, NP), a digital signal processor (digital signal processor, DSP), a microprocessor, a microcontroller, a programmable logic device (programmable logic device, PLD), or any combination thereof. Alternatively, the processor 701 may be another apparatus having a processing function, for example, a circuit, a component, or a software module. This is not limited.

The transceiver 702 is configured to communicate with another device or another communication network. The another communication network may be an ethernet, a RAN, a WLAN, or the like. The transceiver 702 may be a module, a circuit, a transceiver, or any apparatus that can implement communication.

The communication line 703 is configured to perform information transmission between the components included in the communication apparatus 700.

The memory 704 is configured to store instructions. The instructions may be computer programs.

The memory 704 may be a read-only memory (read-only memory, ROM) or another type of static storage device that can store static information and/or instructions; may be a random access memory (random access memory, RAM) or another type of dynamic storage device that can store information and/or instructions; or may be an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Blue-ray disc, or the like), a magnetic disk storage medium or another magnetic storage device, or the like. This is not limited.

It should be noted that the memory 704 may exist independently of the processor 701, or may be integrated with the processor 701. The memory 704 may be configured to store instructions, program code, some data, or the like. The memory 704 may be located inside the communication apparatus 700, or may be located outside the communication apparatus 700. This is not limited. The processor 701 is configured to execute the instructions stored in the memory 704, to implement a communication method provided in the following embodiment of this application.

In an example, the processor 701 may include one or more CPUs, for example, a CPU 0 and a CPU 1 in FIG. 7.

In an optional implementation, the communication apparatus 700 includes a plurality of processors. For example, in addition to the processor 701 in FIG. 7, the communication apparatus 700 may further include a processor 707.

In an optional implementation, the communication apparatus 700 further includes an output device 705 and an input device 706. For example, the input device 706 is a device, for example, a keyboard, a mouse, a microphone, or a joystick, and the output device 705 is a device, for example, a display or a speaker (speaker).

It should be noted that the communication apparatus 700 may be a desktop computer, a portable computer, a network server, a mobile phone, a tablet computer, a wireless terminal, an embedded device, a chip system, or a device having a structure similar to that in FIG. 7. In addition, a composition structure shown in FIG. 7 does not constitute a limitation on the communication apparatus. In addition to the components shown in FIG. 7, the communication apparatus may include more or fewer components than those shown in the figure, or some components may be combined, or different component arrangements may be used.

In this embodiment of this application, the chip system may include a chip, or may include a chip and another discrete component.

In addition, actions, terms, and the like in embodiments of this application may be mutually referenced. This is not limited. In embodiments of this application, names of messages exchanged between devices, names of parameters in the messages, or the like are merely examples. Other names may alternatively be used during specific implementation. This is not limited.

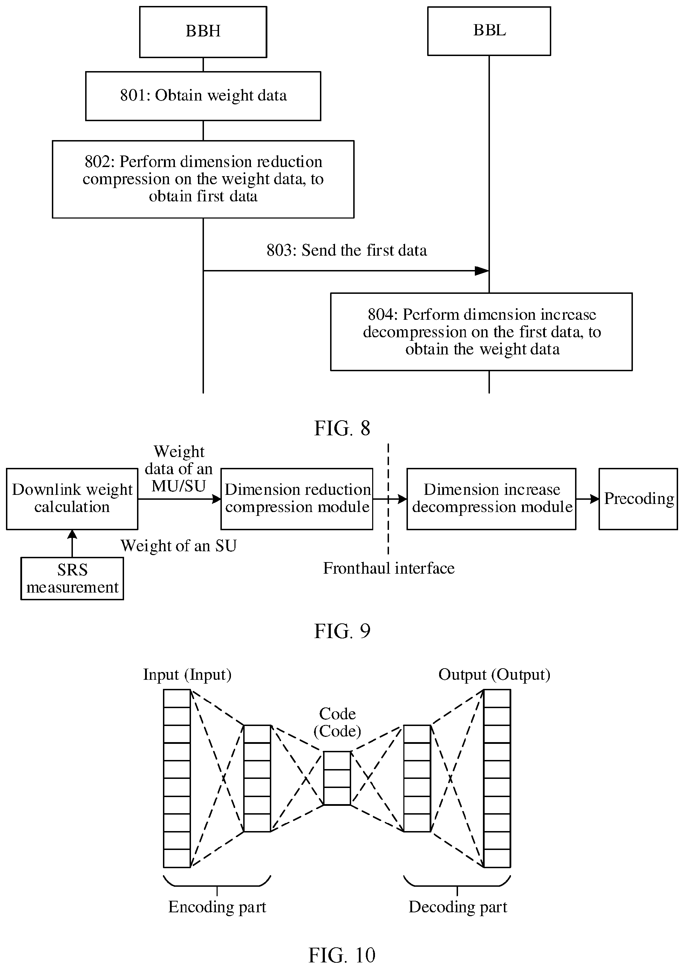

Refer to FIG. 8. The communication method according to embodiments of this application is described with reference to the communication systems shown in FIG. 3 to FIG. 6 and by using an example in which a first communication apparatus is a BBH and a second communication apparatus is a BBL. Both the BBH and the BBL in the following embodiments may have the components shown in FIG. 7. Processing performed by a single execution entity shown in embodiments of this application may alternatively be performed by a plurality of execution entities. These execution entities may be logically and/or physically separated. This is not limited.

FIG. 8 shows a communication method according to an embodiment of this application. As shown in FIG. 8, the method may include the following steps.

Step 801: The BBH obtains weight data.

The weight data may be used for beamforming. Alternatively, it is described as follows: The weight data is a weight that is calculated by the BBH based on channel information fed back by a terminal device and that is used for beamforming, a preconfigured weight, a weight configured by an operation and maintenance personnel through an operation interface, or a weight that is estimated by the BBH through measurement of an uplink reference signal and that is used for beamforming. The value may be multiplied by a data part in a precoding phase to form a directional beam, to achieve an effect of space division multiplexing. Alternatively, it may be described as follows: The weight data is weight data used for performing a precoding operation on user data.

For example, the weight data may be determined by using a conventional precoding matrix determining method. For example, it is assumed that uplink and downlink are mutually different. As shown in FIG. 9, the access network device may receive an uplink reference signal, for example, a channel sounding reference signal (sounding reference signal, SRS) from the terminal device, perform signal measurement/channel estimation on the received SRS to obtain weights of single-users (single-user, SU), and perform downlink weight calculation on the weights of the SUs to obtain weight data (or described as precoding weight data) of a multi-user/single-user (multi-user/single-user, MU/SU).

The weight data may be a multi-dimensional matrix, and is related to a quantity of RBs, a quantity of antennas, and a quantity of streams. The weight data is in a multiplication relationship. As the quantity of antennas and the quantity of streams increase, the weight data synchronously increases.

For example, a dimension of the weight data is the quantity of antennas*the quantity of streams*the quantity of RBs. The quantity of streams may also be described as a quantity of ports (port). In other words, the dimension of the weight data is the quantity of antennas*the quantity of ports*the quantity of RBs.

For example, a fronthaul interface is an eCPRI, and a communication scenario is an eCPRI splitting scenario in which downlink is split before a precoding process based on the form of cat A, cat D, cat E, or cat F shown in FIG. 6. In the eCPRI splitting scenario, weight data may be generated through calculation in the BBH, and data precoding is performed in the BBL.

Step 802: The BBH performs dimension reduction compression on the weight data, to obtain first data.

The dimension of the weight data may be greater than a dimension of the first data.

Specifically, singular value decomposition (singular value decomposition, SVD) is performed on the weight data, so that it may be found that a quantity of non-zero eigenvalues is the quantity of streams. Because the quantity of streams is excessively high, performance is reduced, and a quantity of streams of the weight data is generally less than 50% of the quantity of antennas, it may be determined that the weight data has specific sparsity.

Because the weight data has specific sparsity and the weight data is not encoded and compressed, theoretically, there is large compression space to reduce a data amount of the weight data. Therefore, the dimension of the weight data may be reduced in a dimension reduction compression manner, to reduce the data amount of the weight data, and implement data compression.

For example, the weight data is calculated in the BBH. After the weight data is calculated in the BBH and before the weight data forms an eCPRI frame, the BBH may perform dimension reduction compression on the weight data, to reduce the dimension of the weight data, and implement an objective of data compression.

Optionally, as shown in FIG. 9, a dimension reduction compression module (or described as a dimension reduction module) may be added to the BBH, to implement dimension reduction compression on the weight data.

Optionally, if a first condition is satisfied, the BBH performs dimension reduction compression on the weight data, to obtain the first data.

The first condition may include that a first transmission parameter associated with the weight data is greater than or equal to a first preset threshold, or a second transmission parameter associated with the weight data is less than or equal to a second preset threshold. The first transmission parameter may include one or more of the following: a quantity of streams, a quantity of antennas, a bandwidth, or fronthaul load, and the second transmission parameter may include a weight granularity.

For example, if the first transmission parameter includes a quantity of streams, the first condition may be that the quantity of streams associated with the weight data is greater than or equal to a preset stream quantity threshold (that is, the first preset threshold). For example, if the first transmission parameter includes a quantity of antennas, the first condition may be that the quantity of antennas associated with the weight data is greater than or greater than or equal to a preset antenna quantity threshold (that is, the first preset threshold). For example, if the first transmission parameter includes a bandwidth, the first condition may be that the bandwidth associated with the weight data is greater than or greater than or equal to a preset bandwidth threshold (that is, the first preset threshold). For example, if the first transmission parameter includes fronthaul load, the first condition may be that the fronthaul load associated with the weight data is greater than or greater than or equal to a preset fronthaul load threshold (that is, the first preset threshold). For example, if the second transmission parameter includes a weight granularity, the first condition may be that the weight granularity associated with the weight data is less than or less than or equal to a preset weight granularity threshold (that is, the second preset threshold).

The first preset threshold and/or the second preset threshold may be preset in a protocol, or may be customized by the access network device such as the BBU or the BBH or obtained through calculation. This is not limited.

Optionally, the BBH performs dimension reduction compression on the weight data based on a first compression rate, to obtain the first data.

For example, the first compression rate may be preset in a protocol, or the first compression rate may be determined by the BBH based on one or more of the following parameters: a quantity of streams, a quantity of antennas, a weight granularity, a bandwidth, fronthaul load, or the like. This is not limited.

For example, a larger quantity of streams indicates a higher first compression rate determined by the BBH based on the quantity of streams. A larger quantity of antennas indicates a higher first compression rate determined by the BBH based on the quantity of antennas. A smaller weight granularity indicates a higher first compression rate determined by the BBH based on the weight granularity. A larger bandwidth indicates a higher first compression rate determined by the BBH based on the bandwidth. Larger fronthaul load indicates a higher first compression rate determined by the BBH based on the fronthaul load.

A higher first compression rate indicates a higher loss of the weight data, and a lower first compression rate indicates a lower loss of the weight data.

In another example, a fixed first compression rate may be set, or a fixed data loss may be set, so that the BBH automatically adjusts the first compression rate. When the first compression rate is fixed, the data loss is floating. When the data loss is fixed, the first compression rate is floating.

Optionally, the first compression rate may also be described as a dimension reduction depth, a dimension reduction compression depth, a dimension reduction degree, a dimension reduction compression degree, or the like. This is not limited.

Optionally, a difference between the dimension of the weight data and the dimension of the first data is a first difference, and an absolute value of a difference between a second compression rate determined based on the first difference and the first compression rate may be less than or equal to the first threshold.

The first compression rate described above is a requirement value (or described as a reference value, an ideal value, or the like) of a compression rate when the BBH performs dimension reduction compression on the weight data. After the BBH performs dimension reduction compression on the weight data based on the requirement value, and then the obtained first data is compared with the weight data, an absolute value of a difference between an actual compression rate and the requirement value may be less than or equal to the first threshold. The actual compression rate may be the second compression rate.

Optionally, the BBH performs dimension reduction compression on the weight data in one or more of the following manners, to obtain the first data: a principal component analysis (principal component analysis, PCA) manner, a discrete cosine transform (discrete cosine transform, DCT) manner, or an autoencoder (AutoEncoder) manner.

In a first example, the BBH may perform dimension reduction compression on the weight data in a PCA manner, to obtain the first data.

A main idea of the PCA manner is to map an n-dimensional feature to a k-dimensional feature, and the k-dimensional feature may also be referred to as a principal component. n and k are positive integers, and n is greater than k.

For example, the BBH may calculate a covariance matrix of a weight matrix (that is, the weight data), calculate an eigenvalue and an eigenvector of the covariance matrix, and select, as the first data, a matrix including first k features with largest eigenvalues and corresponding eigenvectors, so that the weight data may be converted (or described as projecting) into new space, to implement feature dimension reduction.

In a second example, the BBH may perform dimension reduction compression on the weight data in a DCT manner, to obtain the first data.

In the DCT manner, data in space domain may be transformed to data in frequency domain, and good decorrelation performance is provided. The DCT manner has a high energy concentration degree, can aggregate important information of data, and can directly clip unimportant frequency domain area data. A quantization operation is performed on transformed data, and an unimportant coefficient is removed, to achieve an effect of reducing a data dimension. The DCT manner is widely used in image data processing. For example, the DCT manner is used for JPEG image compression. A discrete wavelet transform (discrete wavelet transform, DWT) algorithm is developed by converting a Fourier basis into a wavelet basis, is used in JPGE2000, and has better compression performance.

For example, the BBH may transform spatial domain data of the weight data to a frequency domain, aggregate important information together, and directly clip unimportant frequency domain area data. In other words, the BBH performs a quantization operation on transformed weight data, and removes an unimportant coefficient, to obtain the first data, so as to achieve an effect of reducing a data dimension.

In a third example, the BBH may perform dimension reduction compression on the weight data in an autoencoder manner, to obtain the first data.

An autoencoder is a deep neural network whose input and output are the same, and a data amount of a hidden layer of the autoencoder is far less than that of an input layer. A hidden feature in data can be extracted by using the deep neural network, and less data represents an original output, to achieve an effect of dimension reduction.

For example, as shown in FIG. 10, the autoencoder may be divided into two parts. An encoding (encoder) part is used by the BBH to perform dimension reduction compression on the weight data, to obtain the first data, and a decoding (decoder) part is used by the BBL to perform dimension restoration on the first data, to obtain the weight data.

Based on the foregoing descriptions, when the BBH performs dimension reduction compression on the weight data, if a dimension reduction switch is in an on state, the BBH may perform dimension reduction compression on the weight data, to obtain the first data. Correspondingly, if the dimension reduction switch is in an off state, the BBH cannot perform dimension reduction compression on the weight data.

Optionally, the dimension reduction switch is configured in a main control module. The main control module may be disposed in the BBU, the CU, the DU, or the like. This is not limited.

For example, the main control module may be a universal main processing and transmission unit (universal main processing and transmission unit, UMPT).

The main control module may determine, based on one or more of the following parameters, whether to turn on the dimension reduction switch: a quantity of streams, a quantity of antennas, a weight granularity, a bandwidth, fronthaul load, or the like. This is not limited.

For example, when the quantity of streams is large (the quantity of antennas is large, the weight granularity is small, the bandwidth is large, or the fronthaul load is high), if data traffic is about to exceed a capability of a fronthaul optical module, the dimension reduction switch may be turned on to reduce a data amount, to provide more service traffic.

Optionally, when the dimension reduction switch is in an on state, the BBH may perform dimension reduction compression on the weight data (or described as performing dimension reduction compression on the weight data by using dimension reduction compression module) when the first condition is satisfied. If the first condition is not satisfied, even if the dimension reduction switch is in an on state, the BBH may not perform dimension reduction compression on the weight data.

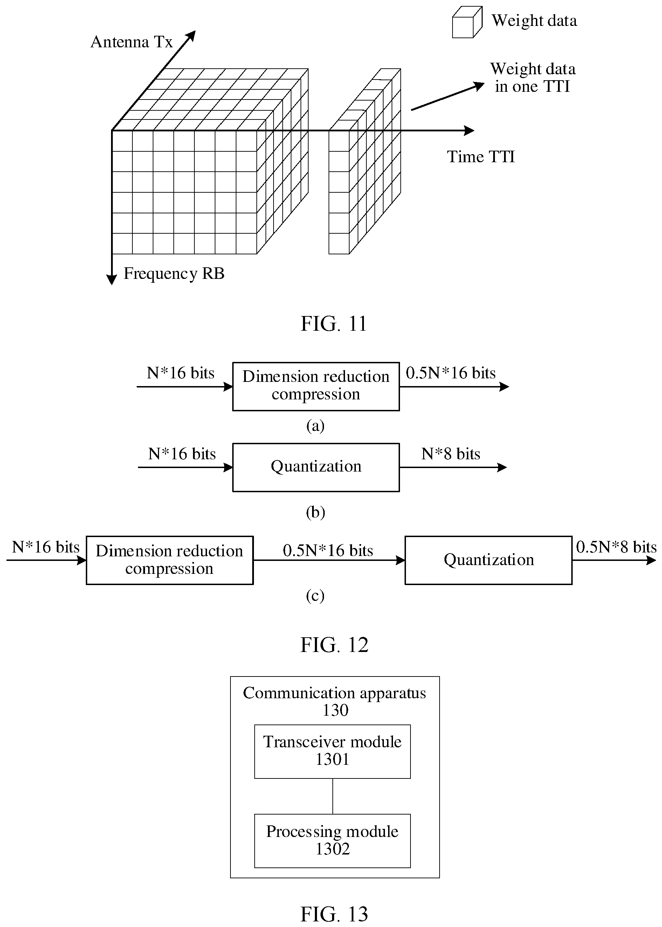

Optionally, when performing dimension reduction compression on the weight data, as shown in FIG. 11, the BBH may perform dimension reduction compression on weight data in TTIs in a unit of one transmission time interval (transmission time interval, TTI), to maximize a weight compression effect.

The TTI is a transmission length for independent decoding on a radio link.

Step 803: The BBH sends the first data, and correspondingly, the BBL obtains the first data.

The BBH may encapsulate the first data into an eCPRI frame, and send encapsulated eCPRI frame to the BBL. When receiving the encapsulated eCPRI frame, the BBL may perform decapsulation to obtain the first data.

Step 804: The BBL performs dimension increase decompression on the first data, to obtain the weight data.

Optionally, the BBL performs dimension increase decompression on the first data based on a first compression rate, to obtain the weight data.

For descriptions of the first compression rate, refer to the foregoing related descriptions of the first compression rate. Details are not described herein.

Optionally, the first compression rate may be obtained by the BBL through calculation, or may be obtained by the BBH through calculation and sent to the BBL. This is not limited.

Optionally, when performing dimension increase decompression on the first data, the BBL may perform dimension increase decompression on the first data in a PCA manner, to obtain the weight data; may perform inverse DCT transform on the first data in a DCT manner, to obtain the weight data; or may decode the first data by using a decoding part in an autoencoder manner, as shown in FIG. 10, to obtain the weight data.

Optionally, a manner in which the BBH performs dimension reduction compression on the weight data is the same as a manner in which the BBL performs dimension increase decompression on the first data.

For example, the manner in which the BBH performs dimension reduction compression on the weight data and the manner in which the BBL performs dimension increase decompression on the first data may be preset. Alternatively, the BBH may determine a manner of performing dimension reduction compression on the weight data, and indicate the used manner to the BBL, and the BBL performs dimension increase decompression on the first data in the manner.

Optionally, as shown in FIG. 9, a dimension increase decompression module (or described as a dimension increase module) may be added to the BBL, to implement dimension increase decompression on the weight data.

Optionally, after performing dimension increase decompression on the first data, to obtain the weight data, the BBL may perform precoding based on the weight data, to form a directional beam, so as to implement beamforming.

Based on the method shown in FIG. 8, dimension reduction compression is performed on the weight data, so that the data amount of the weight data may be reduced, to further reduce a data amount of data sent by the access network device through the fronthaul interface, relieving load of the fronthaul interface, and reducing a bandwidth requirement of the fronthaul interface. Therefore, a larger quantity of streams, a larger quantity of antennas, or a smaller weight granularity can be supported. When a rate of a fronthaul optical module is given, a higher-specification wireless capability is enabled. When development speed of the fronthaul optical module is slow, a possibility that the fronthaul interface becomes a development bottleneck of the communication network is reduced, so that the access network device can adapt to development of the communication network when performing data transmission through the fronthaul interface.

In addition, in this embodiment of this application, dimension reduction compression is performed by using the sparsity of the weight data, so that a fronthaul bandwidth can be saved when a data loss is slight (or described as a data loss is controllable or a radio performance loss is controllable), to implement a level reduction effect of the fronthaul optical module.

For example, as shown in FIG. 2, for example, the weight granularity is 2 RBs and the streams is 32L. Dimension reduction compression is performed on the weight data, and the required switching bandwidth may be reduced from originally "greater than 150 Gbps and less than 200 Gbps" to "greater than 100 Gbps and less than 150 Gbps", and the required eCPRI is reduced from the original "eCPRI of 200 Gbps" to "an eCPRI of 150 Gbps", to achieve a reduction effect.

Different from dimension reduction compression performed on the weight data by the BBH, the BBH may also quantize the weight data, to compress the weight data by reducing a quantity of bits occupied by the weight data, to reduce the data amount of the weight data, and further reduce the data amount of the data sent by the access network device through the fronthaul interface, relieving the load of the fronthaul interface, and reducing the bandwidth requirement of the fronthaul interface. Therefore, the larger quantity of streams, the larger quantity of antennas, or the smaller weight granularity can be supported. When the rate of the fronthaul optical module is given, the higher-specification wireless capability is enabled. When the development speed of the fronthaul optical module is slow, a possibility that the fronthaul interface becomes a development bottleneck of the communication network is reduced, so that the access network device can adapt to the development of the communication network when performing data transmission through the fronthaul interface.

For example, after generating the weight data, the BBH may quantize (or describe as compressing) the weight data. For example, the quantity of bits occupied by the weight data is reduced from 16 bits to 8 bits. In comparison with the weight data before quantization, a 50% quantization compression rate can be implemented. The BBH may send quantized weight data to the BBL. The BBL performs dequantization (or is described as decompression) on the quantized weight data, to obtain the weight data, and implements beamforming based on the weight data through a precoding process.

In the foregoing manner of quantizing the weight data, as the quantity of bits (or described as a quantity of quantized bits) occupied by the weight data decreases, a data loss increases. In the quantization manner, it is difficult to further reduce and compress the quantity of bits occupied by the weight data.

Based on this, the foregoing manner of performing dimension reduction compression on the weight data may be combined with the foregoing manner of quantizing the weight data, to achieve an effect of multiplying a compression capability, and further improve a compression effect of the weight data.

When compressing the weight data, the BBH may first perform dimension reduction compression on the weight data, and then perform quantization; or may first quantize the weight data, and then perform dimension reduction compression on quantized weight data. This is not limited.

For example, the BBH first performs dimension reduction compression on the weight data, and then performs quantization. The BBH may perform dimension reduction compression on the weight data, to obtain the first data, and quantize the first data, to obtain quantized first data. The BBH may send the quantized first data to the BBL. The BBL dequantizes the quantized first data, to obtain the first data, and performs dimension increase decompression on the first data, to obtain the weight data.

For example, the first compression rate of dimension reduction compression is 0.5, and the quantization compression rate is 0.5. It is assumed that the dimension of the weight data is N, and the quantity of occupied bits is 16 bits. As shown in (a) in FIG. 12, after the BBH performs dimension reduction compression on the weight data, the weight data may be compressed from N*16 bits to 0.5N*16 bits. As shown in (b) in FIG. 12, after the BBH quantizes the weight data, the weight data may be compressed from N*16 bits to N*8 bits. As shown in (c) in FIG. 12, after the BBH performs dimension reduction compression and quantization on the weight data, the weight data may be compressed from N*16 bits to 0.5N*8 bits, to achieve an effect of multiplying a compression capability, and further improve an effect of compressing the weight data.

Optionally, in this application, data is compressed from a data layer of the fronthaul interface, instead of an air interface physical layer. A reason why user data is not compressed is that source coding has been performed on the user data (such as a video, a file, and encrypted data). Data redundancy has reduced in a source coding process. The user data is compressed through dimension reduction compression. Theoretically, a gain is not large, but the compression is not completely impossible. In other words, the foregoing process of dimension reduction compression and redundancy removal may still be applied to the user data, to further improve a compression effect of data of the fronthaul interface.

It should be noted that the methods provided in embodiments of this application may be implemented separately, or may be implemented in combination. This is not limited.

It may be understood that, in embodiments of this application, an execution entity may perform some or all of the steps in embodiments of this application. The steps or operations are merely examples. Embodiments of this application may further include performing other operations or variations of various operations. In addition, the steps may be performed in different sequences presented in embodiments of this application, and not all the operations in embodiments of this application may need to be performed.

The solutions provided in embodiments of this application are mainly described above from a perspective of interaction between the devices. It may be understood that, to implement the foregoing functions, each device includes a corresponding hardware structure and/or a corresponding software module for performing each function. A person of ordinary skill in the art should easily be aware that, in combination with algorithms and steps in the examples described in embodiments disclosed in this specification, this application can be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the devices may be divided into functional modules based on the foregoing method examples. For example, each functional module may be obtained through division based on each corresponding function, or two or more functions may be integrated into one processing module. The integrated module may be implemented in the form of hardware, or may be implemented in the form of a software functional module. It should be noted that, in embodiments of this application, module division is an example, and is merely a logical function division. In actual implementation, another division manner may be used.

When each functional module is obtained through division based on each corresponding function, FIG. 13 shows a communication apparatus 130. The communication apparatus 130 may perform actions performed by the first communication apparatus (such as the BBH) in FIG. 8 to FIG. 12, or perform actions performed by the second communication apparatus (such as the BBL) in FIG. 8 to FIG. 12. This is not limited.

The communication apparatus 130 may include a transceiver module 1301 and a processing module 1302. For example, the communication apparatus 130 may be a software module, a hardware circuit, or a software module plus a hardware circuit, or may be a chip used in the communication apparatus, another combined component or component that has a function of the foregoing communication apparatus, or the like. When the communication apparatus 130 is a hardware apparatus, the transceiver module 1301 may be a transceiver. The transceiver may include an interface circuit, a pin, an antenna, a radio frequency circuit, or the like. The processing module 1302 may be a processor (or a processing circuit), for example, a baseband processor. The baseband processor may include one or more CPUs. When the communication apparatus 130 is a component that has a function of the communication apparatus, the transceiver module 1301 may be a radio frequency unit, and the processing module 1302 may be a processor (or a processing circuit), for example, a baseband processor. When the communication apparatus 130 is a chip system, the transceiver module 1301 may be an input/output interface of a chip (for example, a baseband chip), and the processing module 1302 may be a processor (or a processing circuit) of the chip system and may include one or more central processing units. It should be understood that the transceiver module 1301 in this embodiment of this application may be implemented by the transceiver or a transceiver-related circuit component, and the processing module 1302 may be implemented by the processor or a processor-related circuit component (or referred to as a processing circuit).

For example, the transceiver module 1301 may be configured to perform all receiving and sending operations performed by the communication apparatus in the embodiments shown in FIG. 8 to FIG. 12, and/or configured to support another process of the technology described in this specification. The processing module 1302 may be configured to perform all operations other than the receiving and sending operations, performed by the communication apparatus in the embodiments shown in FIG. 8 to FIG. 12, and/or configured to support another process of the technology described in this specification.

In another possible implementation, the transceiver module 1301 in FIG. 13 may be replaced with a transceiver, and a function of the transceiver module 1301 may be integrated into the transceiver. The processing module 1302 may be replaced with a processor, and a function of the processing module 1302 may be integrated into the processor. Further, the communication apparatus 130 shown in FIG. 13 may further include a memory.

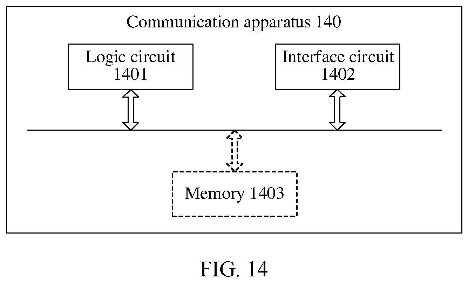

Alternatively, when the processing module 1302 is replaced with a processor, and the transceiver module 1301 is replaced with a transceiver, the communication apparatus 130 in this embodiment of this application may be a communication apparatus 140 shown in FIG. 14. The processor may be a logic circuit 1401, and the transceiver may be an interface circuit 1402. Further, the communication apparatus 140 shown in FIG. 14 may further include a memory 1403.

An embodiment of this application further provides a computer program product. When the computer program product is executed by a computer, a function of any one of the foregoing method embodiments may be implemented.

An embodiment of this application further provides a computer program. When the computer program is executed by a computer, a function of any one of the foregoing method embodiments may be implemented.

An embodiment of this application further provides a computer-readable storage medium. All or some of procedures in the foregoing method embodiments may be implemented by a computer program instructing related hardware. The program may be stored in the foregoing computer-readable storage medium. When the program is executed, the procedures in the foregoing method embodiments may be performed. The computer-readable storage medium may be an internal storage unit in the terminal in any one of the foregoing embodiments (including a data transmit end and/or a data receive end), for example, a hard disk or memory of the terminal. The computer-readable storage medium may also be an external storage device of the foregoing terminal, for example, a plug-in hard disk, a smart media card (smart media card, SMC), a secure digital (secure digital, SD) card, and a flash card (flash card) that are configured on the terminal. Further, the computer-readable storage medium may further include both an internal storage unit and an external storage device of the terminal. The computer-readable storage medium is configured to store the computer program and other programs and data required by the terminal. The computer-readable storage medium may be further configured to temporarily store data that has been output or is to be output.

It should be noted that, in the specification, claims, and accompanying drawings of this application, the terms "first", "second", and the like are intended to distinguish between different objects but do not indicate a particular order. In addition, the terms "including" and "having" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

It should be understood that, in this application, "at least one (item)" means one or more, "a plurality of" means two or more, "at least two (items)" means two, three, or more, and "and/or" is used to describe an association relationship between associated objects, and indicates that there may be three relationships. For example, "A and/or B" may indicate that only A exists, only B exists, and both A and B exist, where A and B may be singular or plural. The character "/" generally indicates an "or" relationship between the associated objects. "At least one of the following items (pieces)" or a similar expression thereof means any combination of these items, including any combination of singular items (pieces) or plural items (pieces). For example, at least one of a, b, or c may indicate a, b, c, a and b, a and c, b and c, or a, b, and c, where a, b, and c may be singular or plural.

The foregoing descriptions about implementations allow a person skilled in the art to understand that, for the purpose of convenient and brief description, division of the foregoing functional modules is taken as an example for description. In actual application, the foregoing functions can be allocated to different functional modules and implemented based on a requirement, that is, an inner structure of an apparatus is divided into different functional modules to implement all or some of the functions described above.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit. The integrated unit may be implemented in the form of hardware, or may be implemented in the form of a software functional unit.

When the integrated unit is implemented in the form of a software functional unit and sold or used as an independent product, the integrated unit may be stored in a readable storage medium. Based on such understanding, the technical solutions in embodiments of this application essentially or all or some of the technical solutions may be implemented in the form of a software product. The software product is stored in a storage medium and includes several instructions for instructing a device (which may be a single-chip microcomputer, a chip or the like) or a processor (processor) to perform all or some of the steps of the methods described in embodiments of this application. The foregoing storage medium includes any medium that can store program code, such as a USB flash drive, a removable hard disk, a ROM, a RAM, a magnetic disk, or an optical disc.

## Claims

1. A communication method, comprising:
obtaining weight data, wherein the weight data is used for beamforming;
performing dimension reduction compression on the weight data, to obtain first data, wherein a dimension of the weight data is greater than a dimension of the first data; and
sending the first data.

2. The method according to claim 1, wherein performing dimension reduction compression on the weight data, to obtain the first data comprises:
if a first condition is satisfied, performing dimension reduction compression on the weight data, to obtain the first data, wherein the first condition comprises that a first transmission parameter associated with the weight data is greater than or equal to a first preset threshold, or a second transmission parameter associated with the weight data is less than or equal to a second preset threshold, the first transmission parameter comprises one or more of the following: a quantity of streams, a quantity of antennas, a bandwidth, or fronthaul load, and the second transmission parameter comprises a weight granularity.

3. The method according to claim 1 or 2, wherein performing dimension reduction compression on the weight data, to obtain the first data comprises:
performing dimension reduction compression on the weight data based on a first compression rate, to obtain the first data.

4. The method according to claim 3, wherein
the first compression rate is preset; or
the first compression rate is determined based on one or more of the following parameters: a quantity of streams, a quantity of antennas, a weight granularity, a bandwidth, or fronthaul load.

5. The method according to any one of claims 1 to 4, wherein performing dimension reduction compression on the weight data, to obtain the first data comprises:
performing dimension reduction compression on the weight data in one or more of the following manners, to obtain the first data: a principal component analysis PCA manner, a discrete cosine transform DCT manner, or an autoencoder manner.

6. The method according to any one of claims 1 to 5, wherein sending the first data comprises:
quantizing the first data, to obtain quantized first data; and
sending the quantized first data.

7. A communication method, comprising:
obtaining first data; and
performing dimension increase decompression on the first data, to obtain weight data, wherein the weight data is used for beamforming, and a dimension of the weight data is greater than a dimension of the first data.

8. The method according to claim 7, wherein performing dimension increase decompression on the first data, to obtain the weight data comprises:
performing dimension increase decompression on the first data based on a first compression rate, to obtain the weight data.

9. The method according to claim 8, wherein
the first compression rate is preset; or
the first compression rate is determined based on one or more of the following parameters: a quantity of streams, a quantity of antennas, a weight granularity, a bandwidth, or fronthaul load.

10. The method according to any one of claims 7 to 9, wherein performing dimension increase decompression on the first data, to obtain the weight data comprises:
performing dimension increase decompression on the first data in one or more of the following manners, to obtain the weight data: a principal component analysis PCA manner, a discrete cosine transform DCT manner, or an autoencoder manner.

11. The method according to any one of claims 7 to 10, wherein obtaining the first data comprises:
receiving quantized first data; and
dequantizing the quantized first data, to obtain the first data.

12. A communication apparatus, comprising:
a transceiver module, configured to obtain weight data, wherein the weight data is used for beamforming; and
a processing module, configured to perform dimension reduction compression on the weight data, to obtain first data, wherein a dimension of the weight data is greater than a dimension of the first data, wherein
the transceiver module is further configured to send the first data.

13. The apparatus according to claim 12, wherein the processing module is specifically configured to:
if a first condition is satisfied, perform dimension reduction compression on the weight data, to obtain the first data, wherein the first condition comprises that a first transmission parameter associated with the weight data is greater than or equal to a first preset threshold, or a second transmission parameter associated with the weight data is less than or equal to a second preset threshold, the first transmission parameter comprises one or more of the following: a quantity of streams, a quantity of antennas, a bandwidth, or fronthaul load, and the second transmission parameter comprises a weight granularity.

14. The apparatus according to claim 12 or 13, wherein the processing module is specifically configured to:
perform dimension reduction compression on the weight data based on a first compression rate, to obtain the first data.

15. The apparatus according to claim 14, wherein
the first compression rate is preset; or
the first compression rate is determined based on one or more of the following parameters: a quantity of streams, a quantity of antennas, a weight granularity, a bandwidth, or fronthaul load.

16. The apparatus according to any one of claims 12 to 15, wherein the processing module is specifically configured to:
perform dimension reduction compression on the weight data in one or more of the following manners, to obtain the first data: a principal component analysis PCA manner, a discrete cosine transform DCT manner, or an autoencoder manner.

17. The apparatus according to any one of claims 12 to 16, wherein
the processing module is further configured to quantize a quantity of bits occupied by the first data, to obtain quantized first data; and
the transceiver module is further configured to send the quantized first data.

18. A communication apparatus, comprising:
a transceiver module, configured to obtain first data; and
a processing module, configured to perform dimension increase decompression on the first data, to obtain weight data, wherein the weight data is used for beamforming, and a dimension of the weight data is greater than a dimension of the first data.

19. The apparatus according to claim 18, wherein the processing module is specifically configured to:
perform dimension increase decompression on the first data based on a first compression rate, to obtain the weight data.

20. The apparatus according to claim 19, wherein
the first compression rate is preset; or
the first compression rate is determined based on one or more of the following parameters: a quantity of streams, a quantity of antennas, a weight granularity, a bandwidth, or fronthaul load.

21. The apparatus according to any one of claims 18 to 20, wherein the processing module is specifically configured to:
perform dimension increase decompression on the first data in one or more of the following manners, to obtain the weight data: a principal component analysis PCA manner, a discrete cosine transform DCT manner, or an autoencoder manner.

22. The apparatus according to any one of claims 18 to 21, wherein
the transceiver module is further configured to receive quantized first data; and
the processing module is further configured to dequantize the quantized first data, to obtain the first data.

23. A communication apparatus, wherein the communication apparatus comprises a processor, the processor is coupled to a memory, and the processor is configured to perform the communication method according to any one of claims 1 to 6.

24. A communication apparatus, wherein the communication apparatus comprises a processor, the processor is coupled to a memory, and the processor is configured to perform the communication method according to any one of claims 7 to 11.

25. A computer-readable storage medium, wherein the computer-readable storage medium stores computer instructions or a program, and when the computer instructions or the program is run on a computer, the communication method according to any one of claims 1 to 6 is performed, or the communication method according to any one of claims 7 to 11 is performed.

26. A computer program product, wherein the computer program product comprises computer instructions, and when some or all of the computer instructions are run on a computer, the communication method according to any one of claims 1 to 6 is performed, or the communication method according to any one of claims 7 to 11 is performed.

27. A communication system, comprising the communication apparatus according to any one of claims 12 to 17 and 23 and the communication apparatus according to any one of claims 18 to 22 and 24.
